(19) Europäisches Patentamt
European Patent Office
Office européen des brevets

(11) Veröffentlichungsnummer: **0 310 915 A1**

(12) **EUROPÄISCHE PATENTANMELDUNG**

(21) Anmeldenummer: **88115875.2**

(51) Int. Cl.4: **C08G 73/06**

(22) Anmeldetag: **27.09.88**

(30) Priorität: **08.10.87 DE 3734040**

(43) Veröffentlichungstag der Anmeldung: **12.04.89 Patentblatt 89/15**

(84) Benannte Vertragsstaaten: **DE FR GB IT**

(71) Anmelder: **BAYER AG**
**Konzernverwaltung RP Patentabteilung**
**D-5090 Leverkusen 1 Bayerwerk(DE)**

(72) Erfinder: **Heywang, Gerhard, Dr.**
**Nittumer Weg 4**
**D-5060 Bergisch Gladbach 2(DE)**
Erfinder: **Jonas, Friedrich, Dr.**
**Krugenofen 15**
**D-5100 Aachen(DE)**
Erfinder: **Merten, Rudolf, Dr.**
**Berta-von-Suttner-Strasse 55**
**D-5090 Leverkusen(DE)**
Erfinder: **Schmidtberg, Werner**
**Am Thelenhof 35**
**D-5090 Leverkusen(DE)**

(54) **Sulfongruppen enthaltende Polyhydantoine.**

(57) Polyhydantoine der allgemeinen Formel

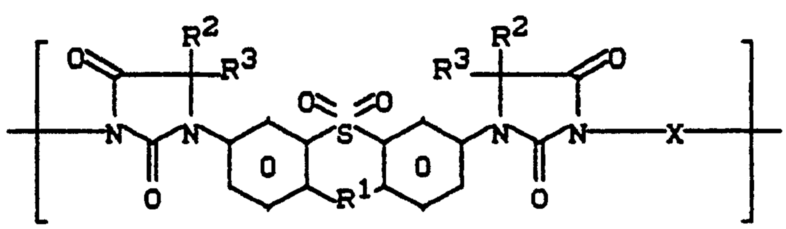

(I),

in der

X für einen zweiwertigen aliphatischen, aromatischen oder araliphatischen Rest steht,
$R^1$ $-CH_2-$, $-\overset{\overset{O}{\|}}{C}-$, $-O-$, $-SO_2-$, $-C(R^5,R^6)-$ bedeutet,
$R^2$ und $R^3$ gleich oder verschieden sind und für Wasserstoff, $C_1$-$C_6$-Alkyl oder gemeinsam für $-(CH_2)_4-$ oder $-(CH_2)_5-$ stehen und
$R^5$ und $R^6$ gleich oder verschieden sind und für $C_1$-$C_6$-Alkyl oder gemeinsam für $-(CH_2)_4-$ oder $-(CH_2)_5-$ stehen,
sind wertvolle hochtemperaturbeständige Polymere, die insbesondere als Folienmaterial Bedeutung haben.

EP 0 310 915 A1

## Sulfongruppen enthaltende Polyhydantoine

Hydantoingruppen enthaltende Polymere und Verfahren zu ihrer Herstellung sind bereits bekannt (DE-AS 15 70 552 und DE-AS 17 95 751). Sie finden Verwendung als temperaturbeständige Drahtlacke oder zur Herstellung temperaturbeständiger Folien. Trotz des beachtlichen Eigenschaftsniveaus dieser Polyhydantoine sind sie nicht für alle Anwendungen in der modernen Elektronikindustrie geeignet. So werden hochtemperaturbeständige Folien für flexible Leiterplatten in elektronischen Schaltungen gefordert. Solche Folien dürfen während der Verarbeitung in einem Lötbad bei Temperaturen über 200 °C nur einen sehr geringen Schrumpf aufweisen. Diese Forderung wird aber von Folien aus bisher bekannten Polyhydantoinen nur unzureichend erfüllt. Es bestand daher der Wunsch, Polyhydantoine zu entwickeln, die bei Temperaturen über 200 °C nur einen geringen Schrumpf aufweisen.

Überraschenderweise wurde gefunden, daß Polyhydantoine der unten aufgeführten Formel (I), die Sulfongruppen enthalten, eine solch hohe geforderte Temperaturbeständigkeit aufweisen.

Die Erfindung betrifft daher Polyhydantoine der Formel

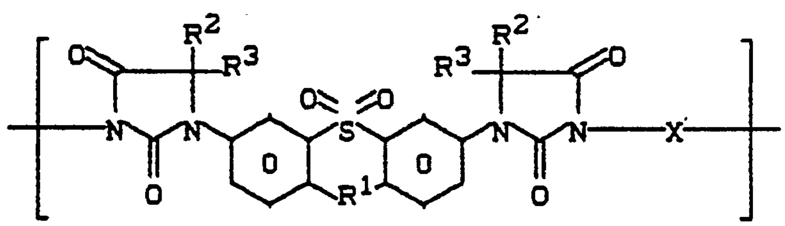 (I),

in der

X für einen zweiwertigen aliphatischen, aromatischen oder araliphatischen Rest steht,
$R^1$ $-CH_2-$, $-\overset{O}{\overset{\|}{C}}-$, -O-, $-SO_2-$, $-C(R^5,R^6)-$ bedeutet,
$R^2$ und $R^3$ gleich oder verschieden sind und für Wasserstoff, $C_1$-$C_6$-Alkyl oder gemeinsam für $-(CH_2)_4-$ oder $-(CH_2)_5-$ stehen und
$R^5$ und $R^6$ gleich oder verschieden sind und für $C_1$-$C_6$-Alkyl oder gemeinsam für $-(CH_2)_4-$ oder $-(CH_2)_5-$ stehen.

Bevorzugte erfindungsgemäße Polyhydantoine sind solche der Formel (I), in denen $R^1$ $-CH_2-$, -O- oder $-(CH_3)_2$-bedeutet.

Weitere bevorzugte erfindungsgemäße Polyhydantoine sind solche der Formel (I), in denen $R^2$ und $R^3$ für Wasserstoff, Methyl oder Ethyl stehen.

Noch weitere bevorzugte erfindungsgemäße Polyhydantoine der Formel (I) sind solche, in denen X für einen der folgenden Reste steht:

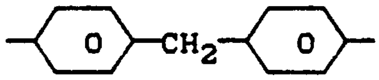 , 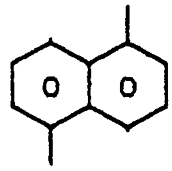 , 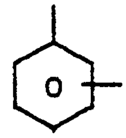 ,

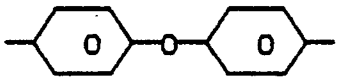 , 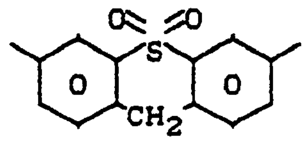 oder

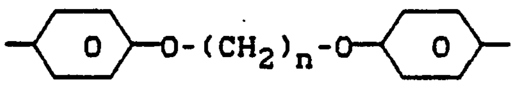 mit $n = 2 - 6$.

Alle erfindungsgemäßen Polyhydantoine sind durch die aus Formel (I) ersichtliche Sulfongruppe gekennzeichnet.

Zur Herstellung der Polyhydantoine nach Formel (I) kann so verfahren werden, daß Bisglycinester der Formel

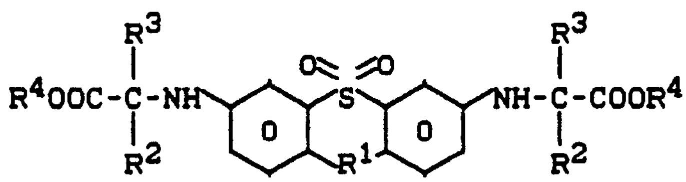

(II),

in der

$R^1$, $R^2$ und $R^3$ die oben genannte Bedeutung haben und
$R^4$ für $C_1$-$C_{10}$-Alkyl oder $C_6$-$C_{10}$-Aryl steht,

mit Diisocyanaten zu substituierten Harnstoffen umgesetzt werden und anschließend diese unter Alkoholabspaltung zu den Polyhydantoinen cyclisiert werden.

Die Herstellung der als Ausgangsmaterialien zu verwendenden Glycinderivate ist im Prinzip bekannt und kann beispielsweise durch direkte Umsetzung der Diamine

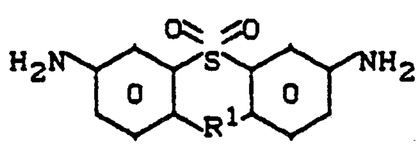

(III),

in der

$R^1$ die oben gegebene Bedeutung hat,

mit Halogenessigsäure oder ihren Derivaten erfolgen.

Die Umsetzung mit Halogenessigsäure bzw. ihren Derivaten erfolgt in organischen Lösungsmitteln, beispielsweise in Ethanol, Methanol, Aceton oder Benzol, oder auch in wäßrigem Milieu unter Mitverwendung von Säurefängern, wie tertiären Aminen (Pyridin, Triethylamin und ähnlichen), überschüssigem Ausgangsamin, Soda, Pottasche, Natriumhydrogencarbonat, Kaliumhydrogencarbonat, Natriumhydroxid, Kaliumhydroxid, Calciumoxid, Calciumcarbonat oder ähnlichen dem Fachmann für diese Zwecke bekannten Stoffen.

Als Halogenessigsäure oder ihre Derivate kommen beispielsweise Chloressigsäure, Chloracetamid, N,N-Dialkylchloracetamid (mit Methyl, Ethyl oder Butyl als Alkylgruppe), Chloressigsäureester (mit Methyl, Ethyl, Phenyl oder ähnlichen als Estergruppe), α-Chlorpropionsäureester oder α-Chlorpropionsäure in

Frage.

Eine weitere Methode zur Herstellung der Bisglycinester der Formel (II) besteht in der Kondensation der Diamine (III) mit Cyaniden, beispielsweise Natriumcyanid oder Kaliumcyanid und Oxoverbindungen (wie Formaldehyd, Aceton, Cyclohexanon und ähnlichen) unter Zusatz von Säuren; die erhaltenen Nitrile können dann in bekannter Weise zu Carbonsäuren verseift oder direkt mit dem gewünschten Alkohol und Säuren wie HCl in die Ester übergeführt werden.

Weitere Verfahren bestehen in der Umwandlung von bereits hergestellten Glycinderivaten, beispielsweise in einer Veresterung der freien Säuren.

Die zur Herstellung der Polyhydantoine benötigten Diisocyanate sind solche der Formel

OCN-X-NCO (IV),

in der

X die oben gegebene Bedeutung hat.

Beispiele hierfür sind Polymethylendiisocyanate OCN-$(CH_2)_n$-NCO mit Werten für n von 4 bis 8, gegebenenfalls alkylsubstituierte Phenylendiisocyanate, wie m-und p-Phenylendiisocyanate, Toluylen-2,4- und -2,6-diisocyanat, Ethylphenylendiisocyanate, Di- und Triisopropylphenylendiisocyanate, Chlor-p-phenylendiisocyanate, Diphenylmethandiisocyanate, Naphthylendiisocyanate, Diphenyletherdiisocyanate oder Thioxanthen-S,S-dioxid-diisocyanate.

Die genannten Diisocyanate können auch in Form von Derivaten eingesetzt werden. Hierbei kommen als Derivate beispielsweise die Umsetzungsprodukte solcher Diisocyanate mit Verbindungen, wie Phenolen, Alkoholen, Aminen, Ammoniak, Disulfid und HCl in Frage. Als einzelne Vertreter solcher Verbindungen seien beispielsweise genannt: Phenol, Kresole, Xylenole, Ethanol, Methanol, Propanol, Isopropanol, Ammoniak, Methylamin, Ethanolamin, Dimethylamin, Anilin, Diphenylamin. Ferner können auch höhermolekulare Addukte, beispielsweise von Diisocyanaten mit Polyalkoholen, wie Ethylenglykol oder Propylenglykol verwendet werden.

Das Verfahren wird im allgemeinen so durchgeführt, daß man die beiden Ausgangskomponenten der Formeln (II) und (IV) längere Zeit erhitzt.

Hierbei werden im wesentlichen äquimolare Mengen des Diisocyanats und des Bisglycinesters eingesetzt. Geringe Abweichungen sind zulässig, beispielsweise 0,8-2,0 Mol, bevorzugt 0,9-1,2 Mol Diisocyanat pro Mol des Bisglycinesters.

Bei überschüssigen Mengen des Diisocyanatsund sofern dieses flüssig ist, kann auf die Mitverwendung eines Lösungs- oder Verdünnungsmittels als Reaktionsmedium verzichtet werden. Es ist jedoch bevorzugt, in einem Lösungs- oder Verdünnungsmittel zu arbeiten, wobei in bevorzugter Weise ein solches Lösungs-/Verdünnungsmittel gewählt wird, in welchem sich das entstehende Polymerisat löst. Das Polymerisat kann dann durch Abdestillieren des Lösungs-/Verdünnungsmittels und des gegebenenfalls überschüssigen Diisocyanats isoliert werden. Weiterhin kann das Polymerisat durch Zusatz eines Fällungsmittels isoliert werden. Solche Fällungsmittel sind beispielsweise aliphatische Alkohole, wie Methanol und Ethanol, Propanol, oder Wasser. Eine solche Ausfällung wird bevorzugt dann angewendet, wenn die Polymerisatlösung keine freien Isocyanatgruppen enthält.

Geeignete Lösungs- bzw. Verdünnungsmittel sind solche, die gegen NCO-Gruppen inert sind und in bevorzugter Weise das entstehende Polymere lösen, wie chlorierte aromatische Kohlenwasserstoffe, aliphatische Kohlenwasserstoffe, Ester und Ketone, weiterhin N-Alkylpyrrolidone, Dimethylsulfoxid, Phenol, Kresole und Dimethylformamid. N-Alkylpyrrolidone, Dimethylsulfoxid, Phenol, Kresole und Dimethylformamid, gegebenenfalls im Gemisch mit einem aromatischen Kohlenwasserstoff, sind bevorzugte Lösungsmittel.

Bei Verwendung der obengenannten Derivate von Isocyanaten können auch andere Lösungsmittel, beispielsweise Alkohole, verwendet werden.

Die Bildung des Hydantoinringes kann formelmäßig etwa wie folgt dargestellt werden:

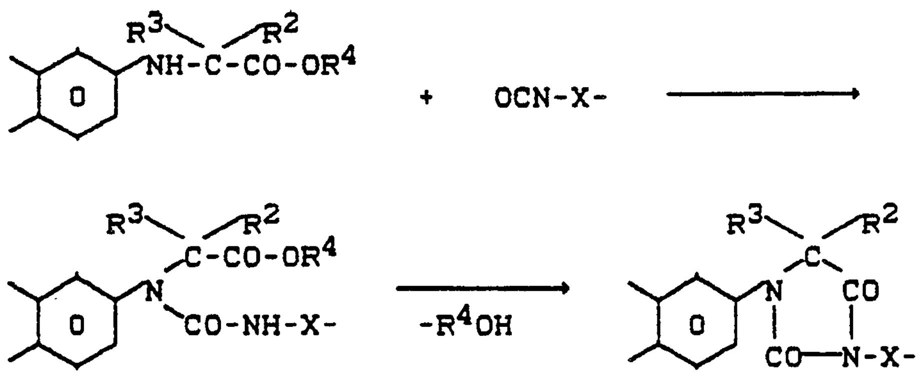


Als Reaktionstemperaturen kommen je nach dem gewählten Ausgangsmaterial solche von 80 bis 300° C in Frage, bevorzugt 100-280° C, besonders bevorzugt 120-250° C. In einer der Fachmann bekannten Weise kann bei den höheren der genannten Temperaturen unter Druck gearbeitet werden, um das Lösungs- bzw. Verdünnungsmittel und die übrigen Reaktionspartner in der flüssigen Phase zu halten.

Die Kondensationsreaktion zur Bildung der Polyhydantoine der Formel (I) kann durch die Mitverwendung von Metallalkoholaten, wie Natriummethylat, Natriumethylat, Titan tetrabutylat, oder tertiären Aminen, wie Triethylamin, Endoethylenpiperazin, als Katalysatoren beschleunigt werden.

Die erfindungsgemäßen, Sulfongruppen enthaltenden Polyhydantoine sind hochtemperaturbeständige Kunststoffe, die etwa bis 350° C stabil bleiben und ausgezeichnete mechanische Eigenschaften besitzen. Sie können die für Kunststoffe üblichen Zusätze, wie Füllstoffe, Pigmente, Antioxidantien, Weichmacher und andere enthalten. Ferner können andere Polymere, wie Polyester, Polyamide, Polyurethane, Polyolefine, Polyacetale, Polyepoxide, Polyimide, Polyamidimide, Polyimino-polyester und Polyimidoisocyanate den erfindungsgemäßen Polyhydantoinen zugemischt werden, wobei das Eigenschaftsspektrum weiteren Anforderungen angepaßt werden kann.

Die erfindungsgemäßen Sulfongruppen enthaltenden Polyhydantoine der Formel (I) eignen sich hervorragend zur Herstellung thermostabiler Formkörper, in bevorzugter Weise zur Herstellung von Folien, die insbesondere bei hohen Gebrauchs- und Verarbeitungstemperaturen nur einen geringen Schrumpf aufweisen. Solche Folien finden beispielsweise Verwendung in der Elektro- und Elektronikindustrie, z.B. zur Herstellung flexibler Leiterplatten.

Beispiel 1

104,12 Gew.-Teile 3,6-Diaminothioxanthen-S-dioxid, 400 Gew.-Teile Methanol und 136 Gew.-Teile Acetoncyanhydrin wurden 24 Stunden unter Rückfluß erhitzt. Nach dem Abkühlen auf 10° C wurde der entstandene Niederschlag abgesaugt und aus Acetonitril umkristallisiert.

Nach dem Trocknen erhielt man 88,2 Gew.-Teile N,N′-Bis-(2-cyanopropyl-2)-3,6-diaminothioxanthen-S-dioxid der Formel

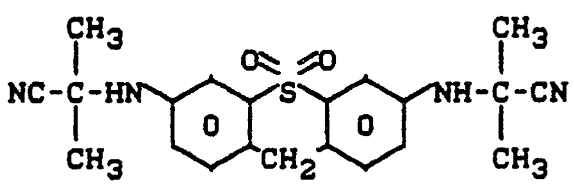

vom Fp.: 174-5° C

| Verbrennungsanalyse | | | | |
|---|---|---|---|---|
| Ber.: | C: 63,9 % | H: 5,6 % | N: 14,2 % | S: 8,1 % |
| Gef.: | C: 63,9 % | H: 5,5 % | N: 14,2 % | S: 8,2 % |

Beispiel 2

In eine gekühlte Vorlage von 423 Gew.-Teilen 96 %iger Schwefelsäure und 350 Gew.-Teilen Methylenchlorid wurden 139 Gew.-Teile N,N′-Bis-(2-cyanopropyl-2)-3,6-diaminothioxanthen-S-dioxid eingetragen. Nach dem Abdestillieren des Methylenchlorids wurden 132 Gew.-Teile Methanol bei 60-80° C zugesetzt. Es wurde 20 Stunden bei 80° C nach gerührt, anschließend auf 2 l Eiswasser ausgegossen und mit verdünnter Natronlauge neutralisiert.

Das weiße, ausgefallene Produkt wurde abgesaugt und nach dem Trocknen aus Dioxan umkristallisiert.

Man erhielt 88 Gew.-Teile N,′N-Bis-(2-carboxymethylpropyl-2)-3,6-diaminothioxanthen-S-dioxid der Formel

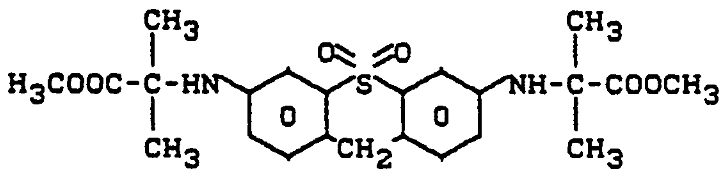

vom Fp.: 220° C

| Verbrennungsanalyse | | | | |
|---|---|---|---|---|
| Ber.: | C: 60 % | H: 6,1 % | N: 6,1 % | S: 7,0 % |
| Gef.: | C: 59,9 % | H: 6,0 % | N: 6,1 % | S: 7,0 % |

Beispiel 3

Zu 23,03 Gew.-Teilen N,N′-Bis-(2-carbomethoxypropyl-2-)-3,6-diaminothioxanthen-S-dioxid, gelöst in 75,6 Gew.-Teilen Kresol und 10 Gew.-Teilen Toluol, werden 0,05 Gew.-Teile Endoethylenpiperazin und 12,5 Gew.-Teile 4,4′-Diisocyanatodiphenylmethan zugesetzt und über 8 Stunden bei 210° C kondensiert. Die Lösung des Polyhydantoins wies nach Verdünnen mit der gleichen Menge Kresol eine Viskosität von 7600 mPas (25° C) auf.

Ein auf einem Stahlblech, bei 300° C, eingebrannter Lackfilm zeigte eine glatte, helle Oberfläche von guter Elastizität.

Durch Eingießen in Methanol wird das Polymere ausgefällt. Man erhielt 31 Gew.-Teile eines gelblichen, grobpulverigen Materials, welches im IR-Spektrum die für ein Hydantoin typischen Banden aufwies.

Herstellung der Folie:

15 Gew.-Teile des gefällten Materials wurden in 85 Gew.-Teilen Methylenchlorid gelöst, entlüftet und auf einer Glasplatte zur Folie ausgezogen. Nach dem Verdunsten des Lösemittels wurde die Folie abgezogen und 1 h bei 160° C getrocknet. Ein 10 cm langer Folienstreifen zeigte bei 260° C im Metallbad keinen Schrumpf. Ein nach DAS 17 95 751, Beispiel 11 hergestelltes Polyhydantoin wurde nach obigem Muster zur Folie verarbeitet.

Ein 10 cm langer Folienstreifen zeigte bei 260° C im Metallbad einen Schrumpf von 5 %.

Beispiele 4 bis 6

Analog Beispiel 1 wurden die folgenden Kombinationen (in Gew.-Teilen) über Kresollösung in Polyhydantoin-Kunststoffe umgewandelt.

Nr. 4
23,03 Gew.-Teile
N,N′-Bis-(2-carbomethoxypropyl-2)-3,6-diaminothioxanthen-S-dioxid

15,61 Gew.-Teile
3,6-Diisocyanato-thioxanthen-S-dioxid;

Nr. 5
23,03 Gew.-Teile
N,N'-Bis-(2-carbomethoxypropyl-2)-3,6-diaminothioxanthen-S-dioxid
12,61 Gew.-Teile
4,4'-Diisocyanato-diphenylether;

Nr. 6
23,03 Gew.-Teile
N,N'-Bis-(2-carbomethoxypropyl-2)-3,6-diaminothioxanthen-S-dioxid
10,51 Gew.-Teile
1,5-Diisocyanato-naphthalin

Die Polyhydantoinlacke nach Beispiel 4 bis 6 wurden auf Stahlbleche bei 300° C eingebrannt. Die so erhaltenen Lackfilme zeigten glatte Oberflächen mit guter Elastizität.

**Ansprüche**

1. Polyhydantoine der allgemeinen Formel

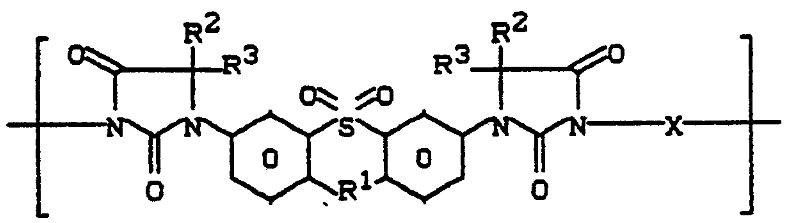
,

in der

X für einen zweiwertigen aliphatischen, aromatischen oder araliphatischen Rest steht,
$R^1$ $-CH_2-$, $-\overset{O}{\overset{\|}{C}}-$, -O-, $-SO_2-$, $-C(R^5,R^6)-$ bedeutet,
$R^2$ und $R^3$ gleich oder verschieden sind und für Wasserstoff, $C_1$-$C_6$-Alkyl oder gemeinsam für $-(CH_2)_4-$ oder $-(CH_2)_5-$stehen und
$R^5$ und $R^6$ gleich oder verschieden sind und für $C_1$-$C_6$-Alkyl oder gemeinsam für $-(CH_2)_4-$ oder $-(CH_2)_5-$ stehen.

2. Polyhydantoine nach Anspruch 1, worin $R^1$ $-CH_2-$, -O-oder $-C(CH_3)_2-$ bedeutet.

3. Polyhydantoine nach Anspruch 1, worin $R^2$ und $R^3$ gleich oder verschieden sind und für Wasserstoff, Methyl oder Ethyl stehen.

4. Polyhydantoine nach Anspruch 1, worin X für einen der Reste

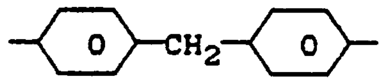 , 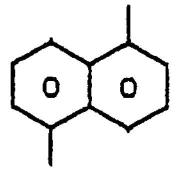 , 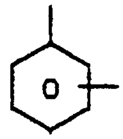 ,

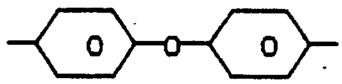 , 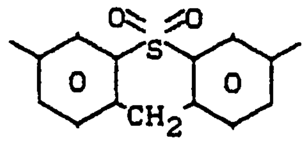 oder

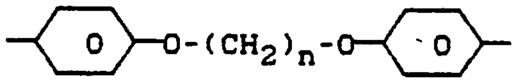 mit n = 2 - 6.

steht.

5. Verfahren zur Herstellung der Polyhydantoine nach Anspruch 1, dadurch gekennzeichnet, daß man Bisglycinester der Formel

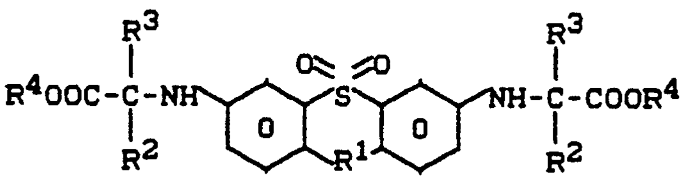 ,

in der

$R^1$, $R^2$ und $R^3$ die in Anspruch 1 genannte Bedeutung haben und
$R^4$ für $C_1$-$C_{10}$-Alkyl oder $C_6$-$C_{10}$-Aryl steht,

mit Diisocyanaten zu substituierten Harnstoffen umsetzt und diese anschließend unter Alkoholabspaltung cyclisiert.

6. Verfahren nach Anspruch 5, dadurch gekennzeichnet, daß 0,5-10 Mol Diisocyanat, bevorzugt 1-3 Mol Diisocyanat pro Mol des Bisglycinesters eingesetzt werden.

7. Verfahren nach Anspruch 5, dadurch gekennzeichnet, daß in einem Lösungsmittel bzw. Verdünnungsmittel gearbeitet wird.

8. Verfahren nach Anspruch 7, dadurch gekennzeichnet, daß als Lösungs- bzw. Verdünnungsmittel N-Alkylpyrrolidone, Dimethylsulfoxid, Phenol, Kresole, Dimethylformamid, gegebenenfalls im Gemisch mit aromatischen Kohlenwasserstoffen eingesetzt werden.

9. Verwendung der Polyhydantoine nach Anspruch 1 zur Herstellung temperaturbeständiger Formkörper.

10. Verwendung der Polyhydantoine nach Anspruch 9, dadurch gekennzeichnet, daß die Formkörper temperaturbeständige Folien sind.

Europäisches Patentamt

# EUROPÄISCHER RECHERCHENBERICHT

Nummer der Anmeldung

EP 88 11 5875

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| A | US-A-3 397 253 (MERTEN et al.)<br>* Ansprüche 1-12, 15-17; Beispiel * &<br>DE - A - 15 70552 (Kat. D)<br>--- | 1-10 | C 08 G 73/06 |
| D,A | DE-B-1 795 751 (BAYER)<br>* Anspruch *<br>--- | 1,5 | |
| A | DE-A-2 009 741 (BAYER)<br>* Anspruch 1 *<br>--- | 1 | |
| A | AT-B- 292 150 (BAYER)<br>* Ansprüche *<br>----- | 1,5,7,8 | |
| | | | RECHERCHIERTE SACHGEBIETE (Int. Cl.3) |
| | | | C 08 G 73/00 |

Der vorliegende Recherchenbericht wurde für alle Patentansprüche erstellt

| Recherchenort | Abschlußdatum der Recherche | Prüfer |
|---|---|---|
| BERLIN | 08-12-1988 | BOEKER R.B. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)